Europäisches Patentamt

European Patent Office

Office européen des brevets

(19)

(11) Veröffentlichungsnummer: **0 319 104**
**A2**

(12) # EUROPÄISCHE PATENTANMELDUNG

(21) Anmeldenummer: 88202730.3

(22) Anmeldetag: 30.11.88

(51) Int. Cl.4: **H03K 12/00**

(30) Priorität: 03.12.87 DE 3740894

(43) Veröffentlichungstag der Anmeldung:
**07.06.89 Patentblatt 89/23**

(84) Benannte Vertragsstaaten:
**DE FR GB SE**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB SE**

(72) Erfinder: **Behler, Thomas**
**Sonnengartenstrasse 11**
**D-8500 Nürnberg 90(DE)**

(74) Vertreter: **Peuckert, Hermann, Dipl.-Ing. et al**
**Philips Patentverwaltung GmbH**
**Wendenstrasse 35 Postfach 10 51 49**
**D-2000 Hamburg 1(DE)**

(54) **Rechteckgenerator.**

(57) Die Erfindung betrifft einen Rechteckgenerator mit einem Operationsverstärker zur Erzeugung eines Rechteckpulses aus einer Wechselspannung. Der Impuls/Pausen-Verhältnis des Rechteckpulses soll einstellbar sein und auch bei unterschiedlichen Amplitudenwerten der Wechselspannung konstant bleiben.

Hierzu wird vorgeschlagen, bei einer Schaltungsanordnung mit einem Rechteckgenerator mit einem Operationsverstärker am invertierenden Eingang eine durch Gleichrichtung und Siebung aus der Wechselspannung gewonnene Gleichspannung und am nichtinvertierenden Eingang eine aus der Wechselspannung abgeleitete weitere Spannung anzuschalten.

Phasenwinkelmeßgeräte

FIG.1

EP 0 319 104 A2

**Rechteckgenerator**

Die Erfindung betrifft einen Rechteckgenerator mit einem Operationsverstärker zur Erzeugung eines Rechteckpulses aus einer Wechselspannung.

Ein bevorzugter Anwendungsfall ist im nachstehenden beschrieben. Für die Übertragung von Nachrichten über Leitungen werden in gewissen Abständen Zwischenverstärker oder Regeneratoren benötigt, für welche eine Stromversorgung vorzusehen ist. Hierzu ist es gebräuchlich, von einer Endstelle aus eine Reihe von Zwischenverstärkerstellen fernzuspeisen. Bei Fernspeisung mit Wechselspannung werden zwischen dem speisenden Netz und der zu versorgenden Übertragungsleitung transformatorische Konstanter eingeschaltet, wodurch einerseits eine galvanische Trennung vom speisenden Netz erreicht und andererseits die in die Übertragungsleitung eingespeiste Spannung unabhängig von Netzspannungsschwankungen wird. Bei verzweigten Kabelnetzen kann es vorkommen, daß eine Kabelstrecke unbeabsichtigt gleichzeitig an zwei Konstantern angeschlossen ist, weil eine weiterführende Strecke nicht nur für die Nachricht durchgeschleift ist, sondern auch eine Verbindung für die Fernspeisespannung besteht. Wird dann beispielsweise zu Reparatur- oder Wartungszwecken ein Konstanter vom Netz abgeschaltet, so besteht Personengefährdung, weil an den Netzspannungsklemmen des vom Netz getrennten Konstanters Spannung anliegt, die vom anderen Ende der Leitung über den dort angeschlossenen Konstanter eingespeist und über den vom Netz abgetrennten Konstanter an die Netzspannungsklemmen übertragen wird.

Zur Abhilfe ist eine Einrichtung vorgesehen, welche beim Abtrennen eines Konstanters vom Netz erkennt, daß noch Spannung von der anderen Seite her anliegt und eine automatische Abschaltung des Konstanters von der Übertragungsleitung bewirkt. Hierzu wird eine Phasenwinkelmessung durchgeführt, weil sich bei Rückwärtseinspeisung von Spannung auf der Leitung der Phasenwinkel zwischen Strom und Spannung um etwa +90 Grad bzw. -90 Grad ändert und diese Änderung als Kriterium für die Umschaltung ausgenutzt wird. Für die Phasenwinkelmessung ist es erforderlich, aus dem Strom- und den Spannungswerten der Wechselspannung Rechteckimpulse abzuleiten.

Der Erfindung liegt die Aufgabe zugrunde, einen Rechteckgenerator anzugeben, der aus einer Wechselspannung Rechteckimpulse erzeugt, deren Impuls/Pausen-Verhältnis einstellbar ist und auch bei unterschiedlichen Amplitudenwerten der Wechselspannung konstant bleibt.

Diese Aufgabe wird gemäß der Erfindung mit einem Rechteckgenerator mit einem Operationsverstärker dadurch gelöst, daß am invertierenden Eingang eine durch Gleichrichtung und Siebung aus der Wechselspannung gewonnene Gleichspannung und am nichtinvertierenden Eingang eine aus der Wechselspannung abgeleitete weitere Spannung anliegt.

Vorteilhafte Ausgestaltungen der Erfindung sind in den Unteransprüchen angegeben.

Im folgenden soll die Erfindung anhand eines Ausführungsbeispiels und der Figuren 1 bis 4 beschrieben werden.

Es zeigen:

Fig. 1 ein Prinzipschaltbild eines Rechteckgenerators

Fig. 2 den Verlauf der eingangsseitigen Wechselspannung

Fig. 3 den Verlauf der Ausgangsspannung

Fig. 4 ein Ausführungsbeispiel für einen Anwendungsfall

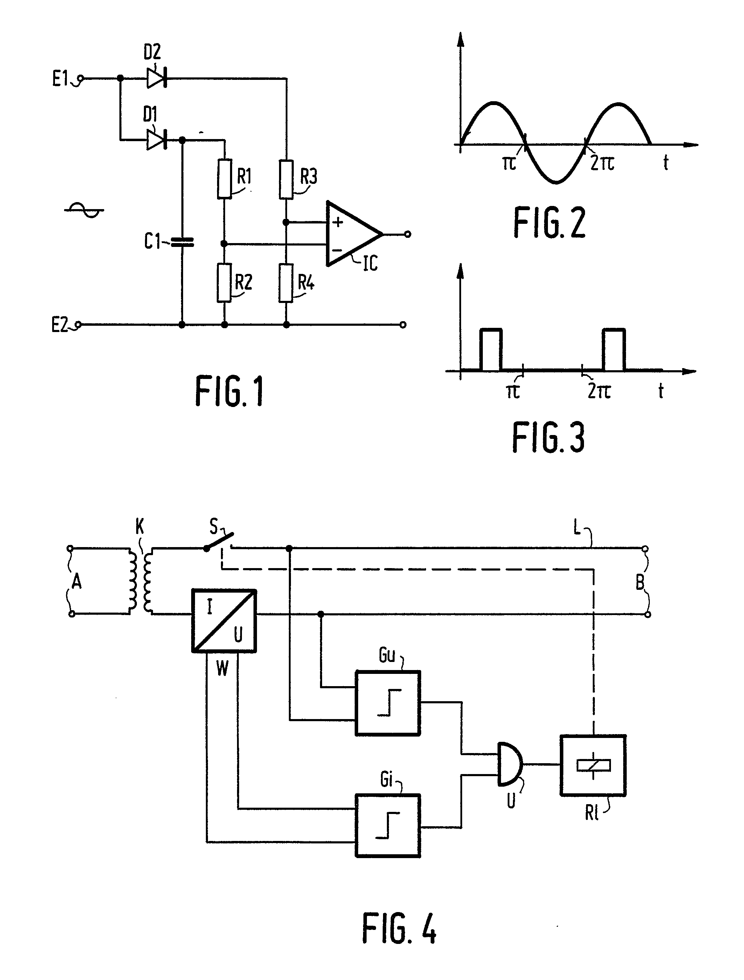

Bei der in Fig. 1 gezeigten Schaltungsanordnung liegt an den Eingangsklemmen E1 und E2 eine sinusförmige Wechselspannung an, deren Verlauf in Fig. 2 dargestellt ist. Der nichtinvertierende Eingang eines Operationsverstärkers IC ist über eine Gleichrichterdiode D2 und einen Widerstand R3 mit der Eingangsklemme E1 und über einen Widerstand R4 mit der Eingangsklemme E2 verbunden. Die beiden Widerstände R3 und R4 bilden einen Spannungsteiler, so daß dem nichtinvertierenden Eingang des Operationsverstärkers IC nur ein durch das Widerstandsverhältnis bestimmbarer Anteil der gleichgerichteten Eingangswechselspannung zugeführt wird.

An dem invertierendem Eingang des Operationsverstärkers IC liegt die Bezugsspannung an. Er ist zu diesem Zweck über eine Gleichrichterdiode D1 und einen in Reihe zu dieser liegenden Widerstand R1 ebenfalls mit der Eingangsklemme E1 und über einen Widerstand R2 mit der Eingangsklemme E2 verbunden. Die beiden Widerstände R1 und R2 bilden ebenfalls einen Spannungsteiler. Parallel zu diesem Spannungsteiler ist ein Kondensator C1 angeordnet. Durch entsprechende Bemessung der Widerstände R1 und R2 des Spannungsteilers ist die Vergleichspannung und damit die Triggerschwelle des mit dem Operationsverstärker IC in dieser Schaltungskonfiguration gebildeten Komparators einstellbar. Die Triggerschwelle bestimmt das Impuls/Pausen-Verhältnis des in der Fig. 3 gezeigten Ausgangspulses.

Durch die dargestellte Anordnung wird erreicht, daß erst nach Ablauf einer vom Impuls/Pausen-Verhältnis des ausgangsseitigen Pulszuges abhängigen Zeit nach dem Nulldurchgang der am Eingang anliegenden Sinuswechselspannung die Vorderflanke des zugehörigem Rechteckimpulses am Ausgang des Operationsverstärkers IC entsteht. Ebenso erscheint die rückwärtige Flanke in einem entsprechenden zeitlichen Abstand vor dem nächsten Nulldurchgang der eingangsseitigen Sinuswechselspannung. Bei einer Änderung der Amplitude der Eingangswechselspannung verändert sich in gleicher Weise die Triggerschwelle, so daß auch bei Schwankungen der Amplitude der Eingangswechselspannung ein konstantes Impuls/Pausen-Verhältnis gewährleistet ist.

Fig. 4 zeigt ein Ausführungsbeispiel für einen in der Einleitung bereits beschriebenen Anwendungsfall. In eine Übertragungsleitung L wird über einen transformatorischen Konstanter K Wechselspannung eingespeist, wobei am primärseitigen Anschlußklemmenpaar A des Konstanters K z.B. das öffentliche Versorgungsspannungsnetz angeschlossen ist. An der Übertragungsleitung sind parallel die zu versorgenden Zwischenverstärker angeschlossen, sie sind aus Gründen der Übersichtlichkeit in Fig. 4 nicht eingezeichnet. Mit einem ersten Rechteckgenerator Gu wird aus der Wechselspannung auf der Leitung L ein Rechteckpuls abgeleitet, der an einem Eingang der UND-Schaltung U anliegt. Aus der Umwandlung Strom/Spannung an einem Strom/Spannungswandler W wird durch einen weiteren Rechteckgenerator Gi ein weiterer Rechteckpuls abgeleitet, der einem zweiten Eingang der UND-Schaltung U zugeführt ist. Bei Normalbetrieb besteht keine oder nur eine sehr geringe Phasenverschiebung zwischen Strom und Spannung auf der Leitung L. Die beiden von den Rechteckgeneratoren Gi und Gu abgegebenen Rechteckpulse sind so eingestellt, daß zwischen ihnen eine Phasenverschiebung von 180 Grad besteht, so daß die UND-Schaltung U keine Ausgangssignal abgibt.

Sobald jedoch eine Speisung der Übertragungsleitung L vom fernen Ende über das Klemmenpaar B über den dort angeschlossenen in der Figur nicht eingezeichneten Konstanter erfolgt, ergibt sich eine Phasenwinkelverschiebung von etwa +90 Grad bzw. -90 Grad.Dies führt dazu, daß sich die Ausgangsimpulse der beiden Rechteckgeneratoren Gi und Gu überlappen, so daß die UND-Bedingung erfüllt ist und das Relais RI angesteuert wird, das den Schalter S zwischen dem Konstanter K und der Leitung L auftrennt. Hierdurch ist eine Personengefährdung vermieden, da über den Konstanter K an das Anschlußklemmenpaar A keine Spannung mehr transformiert werden kann.

Ansprüche

1. Rechteckgenerator mit einem Operationsverstärker zur Erzeugung eines Rechteckpulses aus einer Eingangswechselspannung, dadurch gekennzeichnet, daß dem invertierenden Eingang des Operationsverstärkers eine durch Gleichrichtung und Siebung aus der Eingangswechselspannung gewonnene Gleichspannung und dem nichtinvertierendem Eingang eine aus der Eingangswechselspannung abgeleitete zweite Spannung anliegt.

2. Rechteckgenerator nach Anspruch 1, dadurch gekennzeichnet, daß in Reihe zu einer ersten Gleichrichterdiode (D1) ein erster Spannungsteiler (R1, R2) angeordnet ist, dem ein Kondensator (C1) parallel liegt und dessen Abgriff am invertierenden Eingang des Operationsverstärkers (IC) angeschlossen ist und daß in Reihe zu einer zweiten Gleichrichterdiode (D2) ein zweiter Spannungsteiler (R3, R4) angeordnet ist, dessen Abgriff am nichtinvertierenden Eingang des Operationsverstärkers (IC) angeschlossen ist.

3. Rechteckgenerator nach Anspruch 2, dadurch gekennzeichnet, daß das Impuls/Pausen-Verhältnis des Ausgangsrechteckpulses durch das Teilungsverhältnis des ersten Spannungsteilers (R1, R2) bestimmt ist.

FIG.1

FIG.2

FIG.3

FIG. 4

PHD 87—262